# EUROPEAN PATENT APPLICATION

(11) **EP 4 716 395 A2**
(43) Date of publication of application: **25.03.2026**
(21) Application number: 25203512.6
(22) Date of filing: 19.09.2025
(51) Int. Cl.: H05K 7/20

(54) **LIQUID COOLED RACK PROCESS**

(30) Priority: 23.09.2024 US 202418893310
(71) Applicant: Google LLC, Mountain View, CA 94043 (US)
(72) Inventor: IYENGAR, Madhusudan K., Mountain View, 94043 (US); ZHANG, Feini, Mountain View, 94043 (US)
(74) Representative: Betten & Resch

(57) **Abstract**

A liquid-cooled rack for liquid-cooling trays of computing equipment includes an inlet manifold including an inlet for receiving a coolant at a first temperature and at least one outlet interface for discharging the coolant to one of the liquid-cooled trays; and an outlet manifold including at least one inlet interface for receiving the coolant at a second temperature higher than the first temperature from one of the liquid-cooled trays and an outlet for discharging the coolant. At least one of the inlet manifold or the outlet manifold includes at least one coolant drain port to facilitate the draining and purge drying process. The drain ports can also be added to each tray. The draining and purge drying process can be enhanced by using high pressure air (desiccated and/or heated), flushing with volatile fluid, tilting, vibration, vacuuming.

## Description

### BACKGROUND

Information Technology ("IT") racks hold computing equipment and cooling systems to dissipate heat generated by the computing equipment. Conventional cooling systems use air-cooling to cool the computing equipment. Liquid-cooled systems circulate liquid around the computing equipment and are typically more efficient at dissipating heat generated by the computing equipment than conventional cooling systems. However, transportation of IT racks with liquid cooling can be challenging because of the presence of the liquid coolant in the cooling system.

### BRIEF SUMMARY

According to an aspect of this disclosure, a liquid-cooled rack for liquid-cooling trays of computing equipment comprises an inlet manifold comprising an inlet for receiving a coolant at a first temperature and at least one outlet interface for discharging the coolant to one of the liquid-cooled trays, and an outlet manifold comprising at least one inlet interface for receiving the coolant at a second temperature higher than the first temperature from one of the liquid-cooled trays and an outlet for discharging the coolant. At least one of the inlet manifold or the outlet manifold comprises at least one coolant drain port.

According to an example, at least one outlet interface is configured to releasably connect to an inlet interface of one of the liquid-cooled trays. At least one inlet interface is configured to releasably connect to an outlet interface of one of the liquid-cooled trays.

According to an aspect, each of the inlet manifold and the outlet manifold has a first side facing the liquid-cooled trays and a second side opposite the first side. At least one outlet interface of the inlet manifold and the at least one inlet interface of the outlet manifold are arranged on the first side facing the liquid-cooled trays.

According to an aspect, at least one outlet interface of the inlet manifold and the at least one inlet interface of the outlet manifold are configured to mate with blind mate quick disconnect interfaces of one of the liquid-cooled trays.

In an example, the at least one drain port comprises a plurality of drain ports.

According to another aspect of the disclosure, a liquid-cooled tray for computing equipment comprises a heat sink configured to be in thermal contact with a computing equipment, a coolant inlet on a first side of the tray, a coolant inlet conduit fluidically connecting the coolant inlet to the heat sink, and a coolant drain port fluidically connected to the coolant inlet conduit, the coolant drain port arranged on a second side of the tray.

According to an aspect, the liquid-cooled tray further comprises a coolant outlet on the first side of the tray, and a coolant outlet conduit fluidically connecting the coolant outlet to the heat sink.

According to an aspect, the liquid-cooled tray further comprises a second coolant drain port fluidically connected to the coolant outlet conduit, the second coolant drain port arranged on the second side of the drain.

According to an example, the liquid-cooled tray further comprises a first quick-connect interface connected to the coolant inlet and a second quick-connect interface connected to the coolant outlet. The first quick-connect interface is configured for blind-mating with a corresponding interface of an inlet manifold. The second quick-connect interface is configured for blind-mating with a corresponding interface of an outlet manifold.

According to another aspect, the at least one of the inlet manifold or the outlet manifold includes at least one coolant drain port to facilitate the draining and purge drying process. The drain ports can also be added to each tray. The draining and purge drying process can be enhanced by using high pressure air (desiccated and/or heated), flushing with volatile fluid, tilting, vibration, vacuuming.

According to an aspect of the disclosure, a method comprises filling, with a coolant, a rack manifold of a cooling system of a rack assembly comprising a plurality of trays at a first location through a coolant inlet on the rack manifold, testing thermal performance of the cooling system of the rack assembly, draining the coolant from the rack manifold through at least a coolant drain port on the rack manifold, transporting the rack assembly to a second location, and filling the rack manifold with a coolant at the second location through the coolant inlet.

According to an aspect, the method further comprises purging the rack manifold and filling the rack manifold with nitrogen.

According to an aspect, the method further comprises using high pressure air to purge the coolant from the rack manifold.

According to an aspect, the method further comprises flushing the rack manifold with a volatile fluid.

According to an aspect, the method further comprises tilting and/or vibrating the rack assembly to drain the coolant from the rack assembly.

According to an aspect, the method further comprises vacuuming air from the rack manifold.

According to an aspect, the method further comprises connecting the rack manifold to a coolant delivery unit at the second location.

### BRIEF DESCRIPTION OF THE DRAWINGS

FIG. 1 is a schematic view of a liquid-cooled rack with a plurality of trays according to aspects of the disclosure.
FIG. 2 is a schematic view of a tray according to another aspect of the disclosure.
FIG. 3 is a schematic view of stages of handling a liquid-cooled rack with trays removed and handled separately according to an aspect of the disclosure.
FIG. 4 is a schematic view of stages of handling a liquid-cooled rack with trays integrated and dried after drain and purge according to aspects of the disclosure.
FIG. 5 is a schematic view of various stages of handling and transporting a liquid-cooled rack with some amount of coolant residual after draining and may require climate-controlled logistics according to aspects of the disclosure.
FIG. 6 is a schematic view of various stages of handling and transporting a liquid-cooled rack with high pressure air then vacuum to dry and purge the rack according to aspects of the disclosure.
FIG. 7 is schematic view of various stages of handling and transporting a liquid-cooled rack flushed with volatile fluid then purged clean by vacuuming according to aspects of the disclosure.
FIG. 8 is schematic view of various stages of handling a liquid-cooled rack using acceleration and/or fictitious force by tilting the rack and/or vibration according to aspects of the disclosure.

### DETAILED DESCRIPTION

The technology relates generally to liquid-cooled Information Technology ("IT") racks and processes for handling and transporting the same. IT racks can be air-cooled as well as liquid-cooled. An aspect of the disclosure relates to the handling and transportation of liquid-cooled IT racks. An IT rack may include trays of computing equipment, as well as cooling mechanisms for the computing equipment. Liquid-cooled IT racks use coolants to transport heat away from the computing equipment. Such coolants may require special handling during transportation of the IT racks. For example, liquid coolants may freeze in a cold environment, leading to damages to the cooling equipment. Therefore, climate-controlled transportation and storage spaces may be needed for transporting and storing liquid-cooled IT racks. This is particularly a problem if the liquid coolant is water. While a mixture of water and glycol may be a sub-zero freeze point, providing a little more flexibility, such a mixture may have higher coolant viscosity, which may result in higher pumping costs during operation.

IT racks include inlet manifolds for receiving coolant and directing the same toward the trays of computing equipment and outlet manifolds for receiving coolant heated by the computing equipment and directing the same away from the IR racks. In addition, the IT racks may include one or more drains for draining the coolant from the IT racks, for example, prior to transportation of the IT racks.

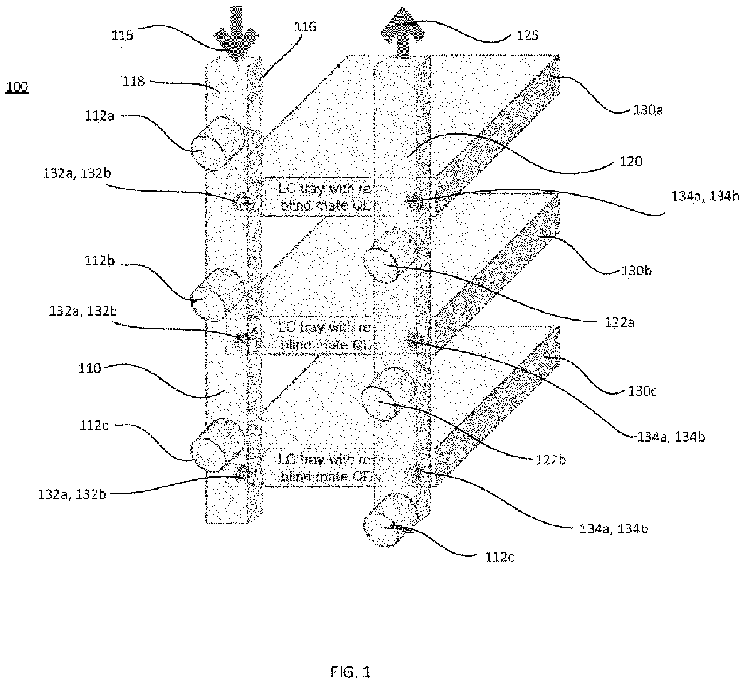

FIG. 1 schematically illustrates an example liquid-cooled IT rack 100. The IT rack 100 includes an inlet manifold 110 and an outlet manifold 120, collectively a cooling system or a rack manifold. The IT rack further includes a plurality of liquid-cooled trays 130a, 130b, 130c, collectively referred to as 130. The inlet manifold 110 includes an inlet 115 for the coolant, a plurality of outlet interfaces 132a, and a plurality of drain ports 112a, 112b, 112c, collectively referred to as 112. The outlet manifold 120 includes an outlet 125 for the coolant, a plurality of inlet interfaces 134a, and a plurality of drain ports 122a, 122b, 122c, collectively referred to as 122. The outlet interfaces 130a are configured to mate with corresponding inlet interfaces 132b of the trays 130. Each of the inlet manifold 110 and the outlet manifold 120 has a first side 116 facing the trays 130 and a second side 118 opposite the first side. The first side 116 of the inlet manifold 110 and the outlet manifold 120 face a rear side of the trays 130. In the illustrated example, the outlet interfaces 132a and the inlet interfaces 134a are located on the first side 116 of the inlet manifold 110 and the outlet manifold 120, respectively. The drain ports 112, 112b, on the other hand, are located on the second side 118 of the inlet manifold 110 and the outlet manifold 120, respectively. In this example of a rectangular manifold, the drain ports can be placed on any six (6) sides: front side, back side, left side, right side, top side, or bottom side. The location can be optimized based on the system design. For other polygon shapes and cylindrical/round shaped manifolds, the drain port can be placed on any sides or any angles that fits to the system design.

While the illustrated example includes three drain ports 112a, 112b, 112c on the inlet manifold 110 and three drain ports 122a, 122b, 122c on the outlet manifold 120, other examples may include different numbers of drain ports on the inlet manifold 110 and the outlet manifold 120. By way of non-limiting examples only, the drain ports 112, 122 may include quick disconnect couplings, Schrader valves, Presta valves, Dunlop valves or drain valves. The illustrated example shows the inlet manifold 110 and the outlet manifold 120 adjacent to one another. In other examples, one of the inlet manifold 110 and the outlet manifold 120 may be at the front of the rack and the other of the inlet manifold 110 and the outlet manifold 120 may be at the back of the rack. In yet other examples, the inlet manifold 110 and the outlet manifold 120 may be diagonally opposite to one another. The front side of the rack is the side where the trays are inserted from into the rack, the back side of the rack is the side opposite to the front side.

Each of the trays 130 has an inlet interface 132b and an outlet interface 134b. The inlet interfaces 132b of the trays 130 are connected to the inlet manifold 110 via the outlet interfaces 132a and the outlet interfaces 134b of the trays 130 are connected to inlet interfaces 134a of the outlet manifold 120. Thus, a coolant introduced into the inlet manifold 110 through the inlet 115 can flow into each of the trays 130 via the corresponding inlet interface 132a and flow out of each of the trays 130 via the corresponding outlet interface 134b into the outlet manifold 120. The coolant can flow out of the outlet manifold through the outlet 125. In an exemplary configuration, the outlet interfaces 132a on the inlet manifold 110 and the inlet interfaces 132b on the trays 130 may be blind-mate disconnect couplings. Likewise, the inlet interfaces 134a on the outlet manifold 120 and the outlet interfaces 134b on the trays 130 may be blind-mate quick disconnect couplings. Such blind-mate quick disconnect couplings may facilitate quick and leak-free coupling and uncoupling of the trays 130 from the inlet manifold 110 and the outlet manifold 120. In the illustrated example, the inlet interfaces 132a and the outlet interfaces 134a are disposed on a rear side of the trays 130. In other examples, the inlet interfaces 132 and the outlet interfaces 134 may be disposed on a front side of the trays 130. In yet other examples, one of the inlet interfaces 132 and the outlet interfaces 134 may be at a front of the trays 130 and the other of the inlet interfaces 132 and the outlet interfaces 134 may be at a rear of the trays 130. In other examples, the inlet interfaces 132 and the outlet interfaces 134 may be at lateral sides of the trays 130, either on the same sides or on different sides. Flexible hoses and manual mating couplings may be used to connect the trays 130 to the inlet manifold 110 and the outlet manifold 120. The front side of the trays 130 is the side facing the operator when the trays 130 are inserted into the rack 100 and the rear side of the trays 130 is the side facing the rear side of the rack 100.

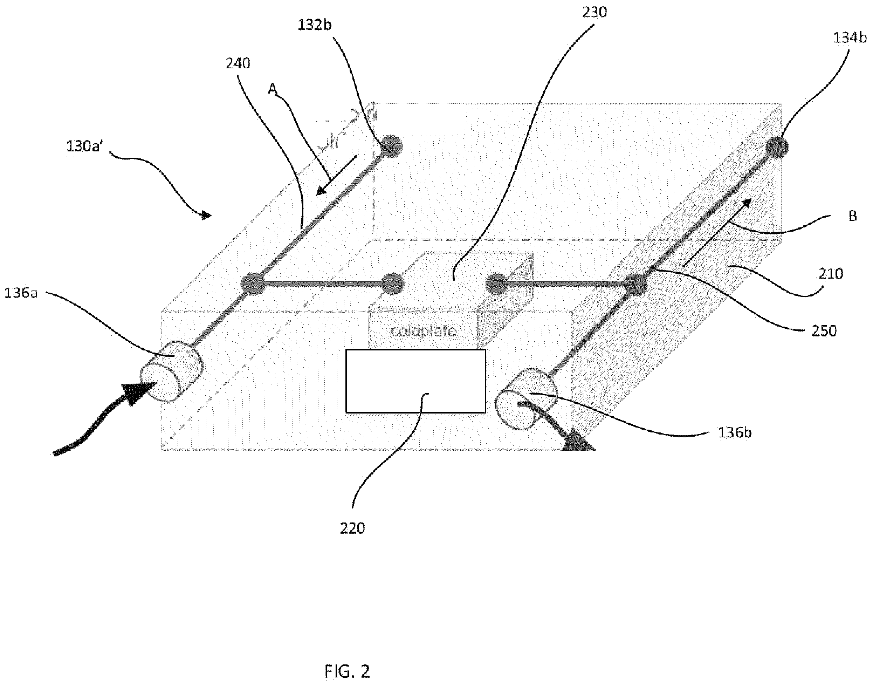

FIG. 2 illustrates tray 130a' schematically according to another example. The tray 130a' includes a body 210 housing a computing equipment 220 and a heat sink 230. The heat sink 230 is in thermal contact with the computing equipment 220 and absorbs the heat generated by the computing equipment. In an example, the heat sink 230 is a cold plate. In another examples, the heat sink 230 can be a combination of heat pipe and a cold-plate assembly, a combination of a vapor chamber and a cold-plate assembly, or a plurality of sub loops with a plurality of cold pates connected in parallel or in series or a mixture of parallel and series flow configuration.

An inlet conduit 240 fluidically connects the inlet interface 132b to the heat sink 230. The inlet conduit 240 leads a coolant introduced into the inlet interface 132b to the heat sink 230. Flow of the coolant into the inlet interface 132 from the inlet manifold 110 is schematically illustrated by an arrow A.

An outlet conduit 250 fluidically connects the heat sink 230 to the outlet interface 134b. After the coolant has absorbed heat from the computing equipment 220 via the heat sink 230, the coolant flows through the conduit 250 to the outlet interface 134b. While the illustrated examples show inlet and outlet conduits 240, 250 as having straight configurations, other examples may include inlet and outlet conduits 240, 250 with other configurations, such as bends and curves. A flow of the coolant flowing out the outlet interface 134a into the outlet manifold 120 is illustrated schematically by an arrow B. During operation of the computing equipment 220, the coolant flowing out of the outlet interface 134 may be at a second temperature higher than a first temperature at which the coolant flows into the inlet interface 132b. In this regard, as the coolant passes through or over the heat sink 230, the coolant absorbs heat generated by the computing equipment 220. In an example, the coolant is water. In another example, the coolant is propylene glycol or a mixture of propylene glycol and water, for example, 25 % propylene glycol (PG25). Other coolants such as ethylene glycol, a mixture of water and ethylene glycol, water, oil, or fluorocarbon engineered or synthetic fluids can also be used.

The tray 130a' further includes a first drain port 136a and a second drain port 136b in the illustrated example. In other examples, the tray 130a' may include more than or fewer than two drain ports. In the illustrated example, the tray 130a' includes the inlet interface 132b and the outlet interface 134b on a rear side of the tray 130a' whereas the drain ports 136a, 136b are located on the front side of the tray 130a'. By way of non-limiting examples only, the drain ports 136a, 136b may include quick disconnect couplings, Schrader valves, Presta valves, Dunlop valves or drain valves. Drain ports 136a, 136b can be placed on any of the six (6) sides of the tray, depending on the system design optimization requirements. The drain port types can be Quick disconnect, Schrader/Presta/Dunlop valve, automotive drain valve etc.

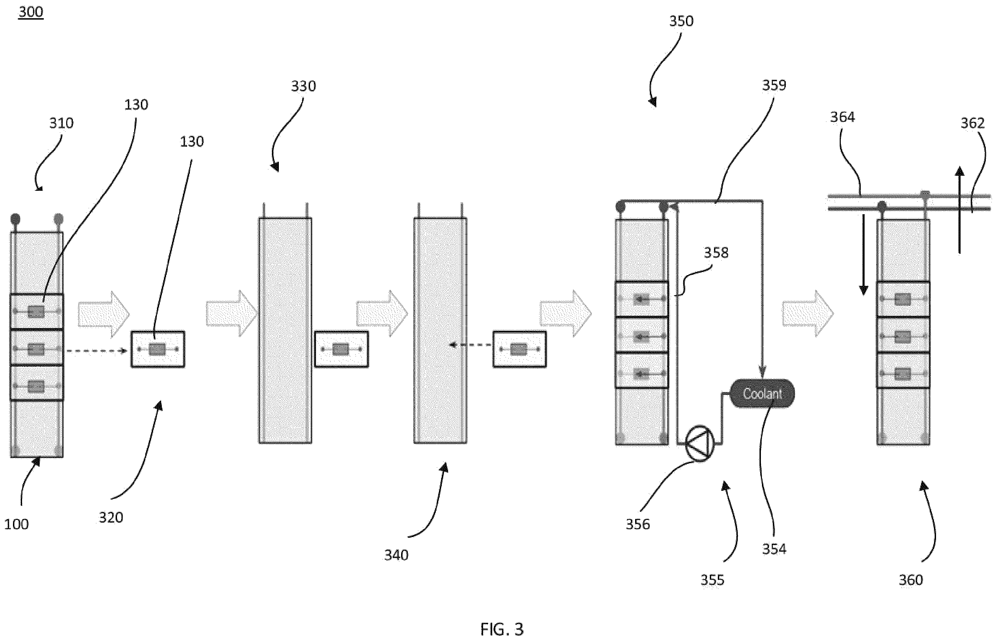

FIG. 3 illustrates a process 300 of handling liquid IT rack 100. While some of the stages in the process 300 are identified individually for ease of discussion, it will be understood that one or more of the illustrated stages can be performed simultaneously, and any one of the identified stages can be broken down into one or more sub-stages. In the first stage 310 of the process 300, the liquid-cooled IT rack 100 is loaded with a plurality of trays 130 at a first location for thermal performance testing. The first location can be a manufacturer's facility, where the IT rack 100 and/or the trays 130 are built and/or assembled. Power is supplied to the trays 130 and the computing equipment 230 is powered on. A coolant, such as water or PG25, is introduced, at a first temperature, into the inlet manifold 110 and into the trays 130 via the corresponding outlet interfaces 132a and the inlet interfaces 132b. The coolant absorbs the heat generated by the computing equipment 230 and the heated coolant flows out of the trays 130 into the outlet manifold 120 and may be heated to a second temperature higher than the first temperature.

Once the thermal performance testing is concluded satisfactorily, coolant is drained out of each of the trays 130 and the trays 130 are removed from the IT rack 100 at the second stage 320. Since each of the trays 130 are removed from the IT rack 100, the trays 130 can be drained and dried individually. However, if the trays 130 are removed from a tested IT rack 100, the rack 100 may have to be tested again when the trays 130 are inserted back into the IT rack 100.

At the third stage 330, the coolant is drained from the outlet manifold 120 and the IT rack 100 is prepared for transportation to a second location. The second location may be a vendor or a final destination of the IT rack, for example, a data center. An advantage of draining the coolant from the IT rack 100 and the trays 130 is that no special handling is required during the transportation. For example, if the coolant were maintained in the IT rack 100 for transportation, climate control would be required to ensure that the coolant is not frozen or overly heated during transportation. Still further, there is a risk of the coolant leaking out of the IT rack 100 and/or the trays 130. Apart from the leakage of the coolant being an issue by itself, the leaked coolant can also damage other equipment during transportation. Such damage can be prevented by draining the coolant out of the IT rack 100 and the trays 130.

At the third stage 340, after the IT rack 100 and the trays 130 have arrived at the second location, the trays 130 are inserted back into the IT rack 100.

At the fourth stage 350, a coolant filling tool 355 is connected to the IT rack 100. In an example, the coolant filling tool 355 includes a reservoir 354 for a coolant, a pump 356, an inlet conduit 358, and an outlet conduit 359 and flow control valves (not shown). The inlet conduit 358 is connected to one of the inlet 115 of the inlet manifold 110 and the outlet 125 of the outlet manifold 120 and the outlet conduit 359 is connected to the other of the inlet 115 of the inlet manifold 110 and the outlet 125 of the outlet manifold 120. A predetermined quantity of the coolant is filled into the IT rack 100 and the trays 130 via the pump 356.

Finally, at the last stage 360, once the IT rack 100 is ready for operation, the coolant filling tool 355 is disconnected and the inlet manifold 110 is connected to a Coolant Distribution Unit (CDU) or facility coolant supply 362 and the outlet manifold 120 is connected to a facility coolant return 364, for example, of a data center.

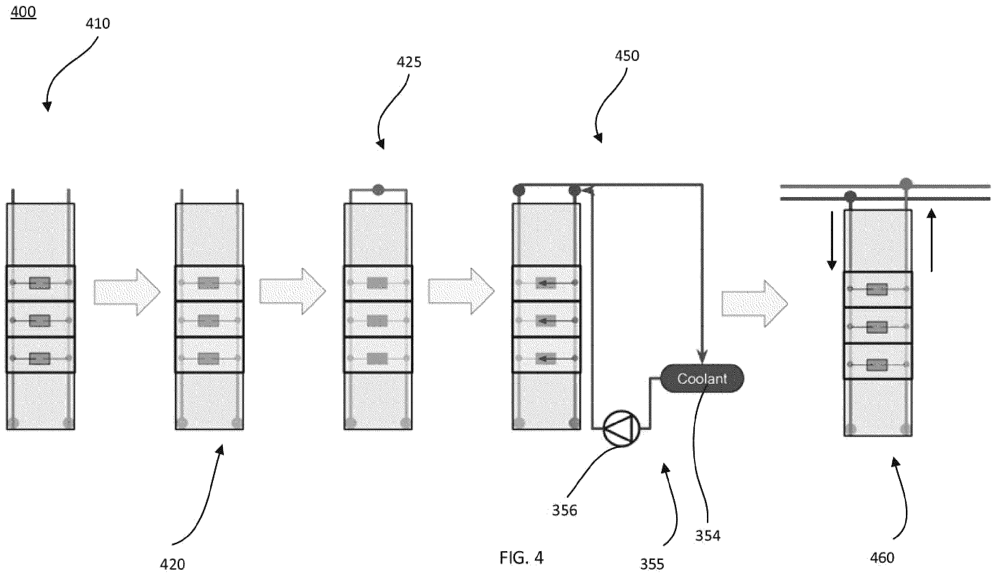

FIG. 4 illustrates various stages of a process 400 of handling a liquid cooled IT rack 100. Stages 410, 450, and 460 are similar to the stages 310, 350, and 360, respectively, described above regarding the process 300. However, stage 420 differs from stage 320 and there is no stage 330 in the process 400. After the coolant is drained from the IT rack 100 and the trays 130 after the functionality testing, the trays 130 are not removed from the IT rack 100. Instead, the trays 130 remain installed in the IT rack 100 while being transported from the first location to the second location. Since the coolant has been drained from the IT rack 100 and the trays 130, no special handling is required as described above. As shown in the stage 425, each of the trays 130 are disconnected from the inlet manifold 110 and the outlet manifold 120, *i.e.*, are isolated from the IT rack 100. This process may be employed when the coupling between the trays 130 and the inlet manifold 110 and the outlet manifold 120 include manual mate couplings, which are easily accessible. Thus, while the trays 130 are isolated from the coolant system of the rack, the rest of the connections of the trays 10 such as power and network connections with the rack 100 are not disconnected. Once the trays 130 are connected to the inlet manifold 110 and the outlet manifold 120, it may need to be tested for leaks, for example.

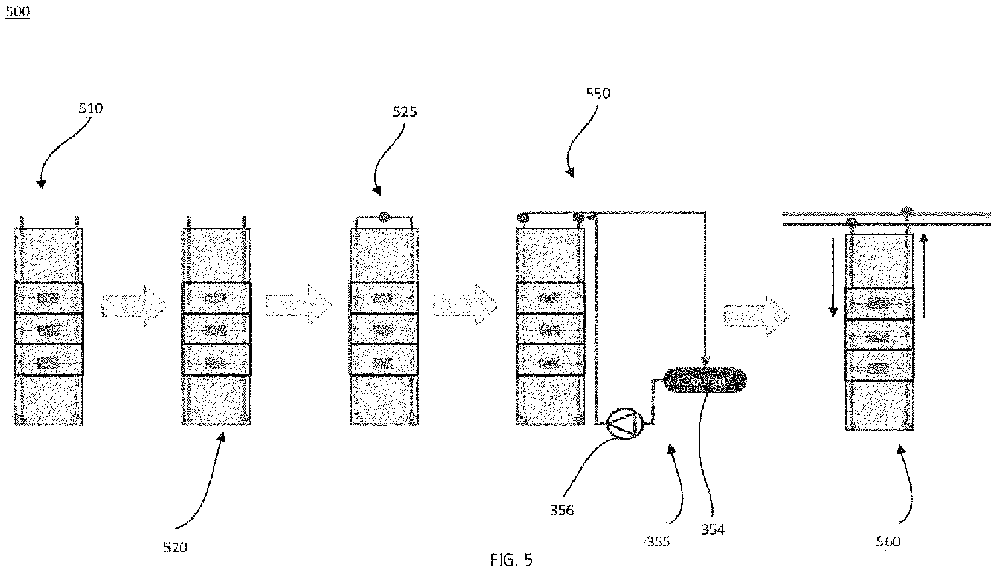

Referring now to FIG. 5, another process 500 of handling a liquid-cooled IT rack 100 is illustrated. While stages 510, 550, and 560 are similar to the stages 310, 350, and 360 described above regarding the process 300, the stage 520 is different. While a majority of the coolant has been drained from the trays 130, in some cases, there may be a residual of about 5% to 15% coolant remaining in the trays 130 at the end of the stage 520. In an example, each tray 130 may be isolated from the inlet manifold 110 and the outlet manifold 120 as shown in stage 525. Furthermore, since there is some coolant left in the trays 130, some form of climate control may be provided during the transportation of the IT rack 100. For example, depending on the type of coolant used, it may be ensured that the ambient temperature of the IT rack stays above a predetermined threshold. In one example, the predetermined threshold may be 0° C if the coolant is water. In other cases, the predetermined threshold may be different depending on the type of the coolant.

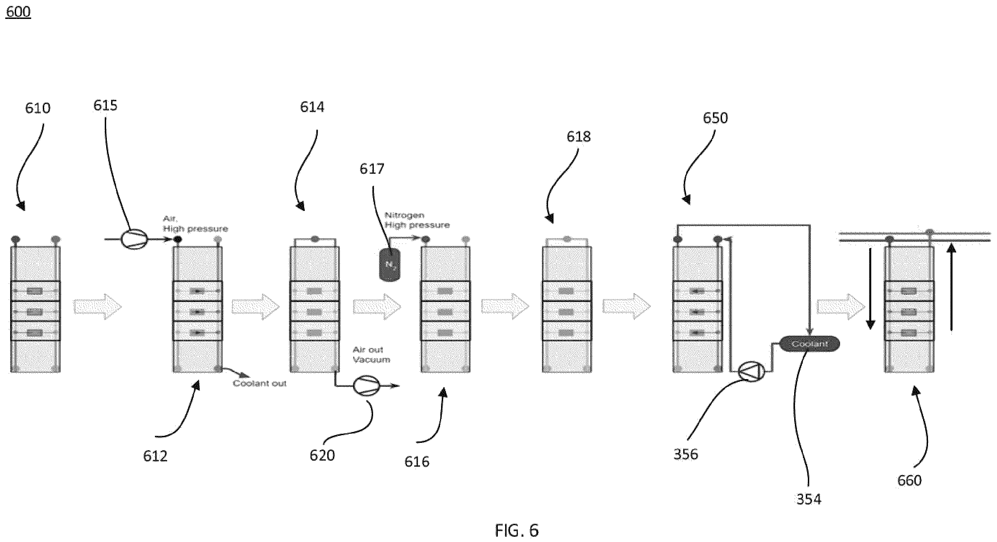

Referring now to FIG. 6, yet another process 600 of handling a liquid-cooled IT rack 100 is illustrated. While stages 610, 650, and 660 are similar to the stages 310, 350, and 360 described above regarding the process 300, the stages 612, 614, 616, and 618 are different. At stage 612, the trays 130 remain installed in the IT rack 100. Coolant is drained from the IT rack 100 and the trays 130. To facilitate the drainage of the coolant, pressurized air may be introduced into the inlet 115, for example, of the inlet manifold 110, for example, using an air compressor 615. For example, air at a pressure ranging from about 1 psig to about 200 psig may be introduced into the inlet manifold 110, depending on the pressure ratings of the components in the rack 100 and the trays 130. In an example, the high-pressure air may be desiccated, and/or heated, to accelerate the purge process. At stage 614, vacuum may be applied at one of the drain ports 112 of the outlet manifold, using a vacuum source 620, to remove any air and moisture from the manifolds 110, 120, and the trays 130. For example, a vacuum in the range of about 0.3 psia to about 0.002 psia may be applied. At stage 616, high pressure nitrogen is introduced into the IT rack 100 and the trays 130 via a nitrogen source 617. For example, nitrogen at a pressure ranging from about 1 psig to about 200 psig may be introduced into the inlet manifold 110, depending on the pressure ratings of the components in the rack 100 and the trays 130. In other example, other gasses may be used instead of nitrogen such as neon and argon. High pressure nitrogen will prevent the entry of any undesired fluid into the system during transportation of the IT rack 100. At stage 618, the IT rack 100 and the trays 130 are sealed with high pressure nitrogen and the IT rack 100 is ready for transportation to the second location.

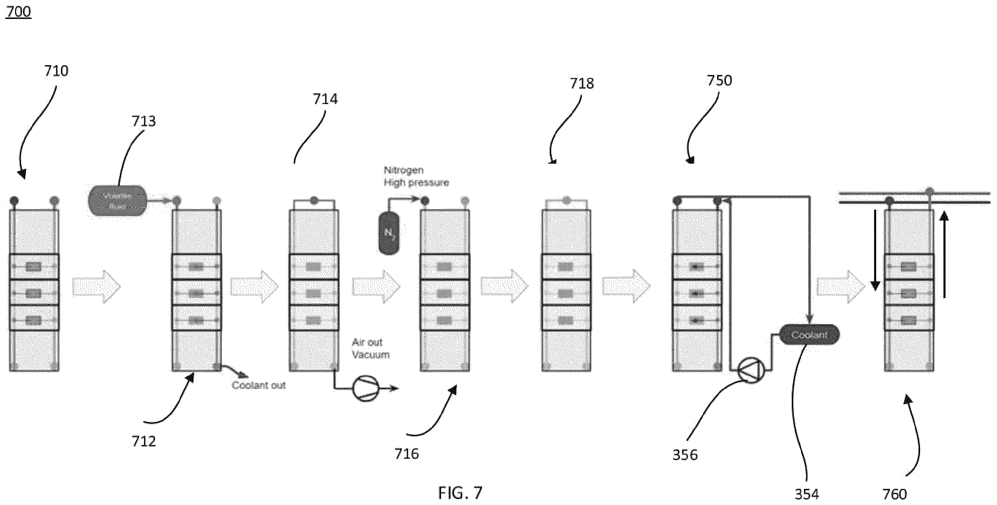

FIG. 7 illustrates yet another process 700 of handling a liquid-cooled IT rack 100. While stages 710, 714, 716, 718, 750, and 760 are similar to the stages 610, 650, 614, 616, 618, and 660 described above regarding the process 600, the stage 712 is different. At stage 712, a volatile fluid from a tank 713 is introduced into the IT rack 100 and the trays 130, instead of pressurized air. Examples of volatile fluids include acetone, alcohol and synthetic fluids having similar characteristics. An advantage of using a volatile fluid is that after flushing the coolant out of the IT rack 100 and the trays 130, the volatile fluid itself evaporates and does not remain in the system. Another advantage is that some of such volatile liquids are biocides, which may prevent bio-growth during transportation. The remnants of the volatile fluid may be removed in the following stage 614 with the help of the vacuum source 620.

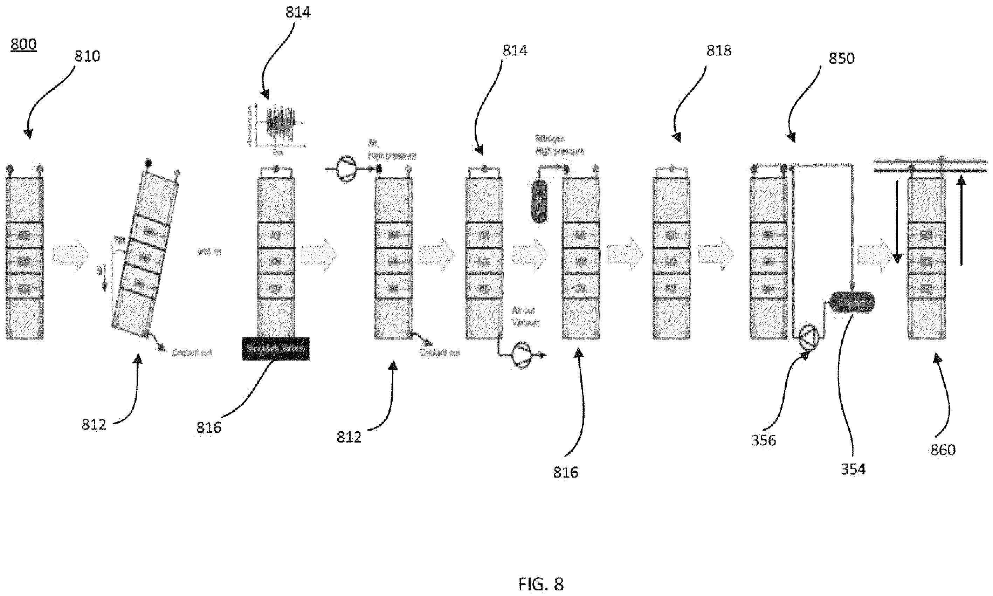

Now referring to FIG. 8, another process 800 of handling a liquid-cooled IT rack 100 is illustrated. While stages 810, 814, 816, 818, 850, and 860 are similar to the stages 710, 750, 712, 714, 716, 718, and 760 described above regarding the process 700, stages 812 and 814 are different. During stage 812, the trays 130 remain installed in the IT rack 100. The rack 100 is tilted to facilitate draining of the coolant out of the IT rack 100 and the trays 130. The IT rack 100 may be tilted by about 5° to about 180° relative to a vertical axis. In addition, or in the alternative, during stage 816, the IT rack 816 may be placed on a platform 816 configured to shock and/or vibrate the IT rack 100 to facilitate drainage of the coolant from the IT rack 100 and the trays 130.

Unless otherwise stated, the foregoing alternative examples are not mutually exclusive, but may be implemented in various combinations to achieve unique advantages. As these and other variations and combinations of the features discussed above can be utilized without departing from the subject matter defined by the claims, the foregoing description of the examples should be taken by way of illustration rather than by way of limitation of the subject matter defined by the claims. In addition, the provision of the examples described herein, as well as clauses phrased as "such as," "including" and the like, should not be interpreted as limiting the subject matter of the claims to the specific examples; rather, the examples are intended to illustrate only one of many possible examples. Further, the same reference numbers in different drawings can identify the same or similar elements.

## Claims

1. A liquid-cooled rack for liquid-cooling trays of computing equipment, the rack comprising:
an inlet manifold comprising an inlet for receiving a coolant and at least one outlet interface for discharging the coolant to one of the liquid-cooled trays; and
an outlet manifold comprising at least one inlet interface for receiving the coolant from one of the liquid-cooled trays and an outlet for discharging the coolant,
wherein at least one of the inlet manifold or the outlet manifold comprises at least one coolant drain port.

2. The liquid-cooled rack according to claim 1, wherein the at least one outlet interface is configured to releasably connect to an inlet interface of one of the liquid-cooled trays; and/or
wherein the at least one inlet interface is configured to releasably connect to an
outlet interface of one of the liquid-cooled trays.

3. The liquid-cooled rack according to claim 1 or claim 2, wherein each of the inlet manifold and the outlet manifold has a first side facing the liquid-cooled trays and a second side opposite the first side.

4. The liquid-cooled rack according to claim 3, wherein the at least one outlet interface of the inlet manifold and the at least one inlet interface of the outlet manifold are arranged on the first side facing the liquid-cooled trays.

5. The liquid-cooled rack according to claim 4, wherein the at least one coolant drain port is arranged on the second side of the inlet manifold or the outlet manifold.

6. The liquid-cooled rack according to any one of claims 1 to 5, wherein the at least one outlet interface of the inlet manifold and the at least one inlet interface of the outlet manifold are configured to mate with blind mate quick disconnect interfaces of one of the liquid-cooled trays; and/or
wherein the at least one drain port comprises a plurality of drain ports.

7. A liquid-cooled tray for computing equipment, the tray comprising:
a heat sink configured to be in thermal contact with a computing equipment;
a coolant inlet on a first side of the tray;
a coolant inlet conduit fluidically connecting the coolant inlet to the heat sink; and
a coolant drain port fluidically connected to the coolant inlet conduit.

8. The liquid-cooled tray according to claim 7, further comprising:
a coolant outlet on the first side of the tray; and
a coolant outlet conduit fluidically connecting the coolant outlet to the heat sink.

9. The liquid-cooled tray according to claim 8, further comprising a second coolant drain port fluidically connected to the coolant outlet conduit.

10. The liquid-cooled tray according to any one of claims 7 to 9, further comprising a first quick-connect interface connected to the coolant inlet and a second quick-connect interface connected to the coolant outlet.

11. The liquid-cooled tray according to claim 10, wherein the first quick-connect interface is configured to blind-mating with a corresponding interface of an inlet manifold; and
wherein the second quick-connect interface is configured for blind-mating with a corresponding interface of an outlet manifold.

12. A method comprising:
filling, with a coolant, a rack manifold of a cooling system of a rack assembly comprising a plurality of trays at a first location through a coolant inlet on the rack manifold;
testing thermal performance of the cooling system of the rack assembly;
draining the coolant from the rack manifold through at least a coolant drain port on the rack manifold;
transporting the rack assembly to a second location; and
filling the rack manifold with a coolant at the second location through the coolant inlet.

13. The method according to claim 12, further comprising purging the rack manifold and filling the rack manifold with nitrogen; and/or
further comprising using high pressure air to purge the coolant from the rack
manifold.

14. The method according to claim 12 or claim 13, further comprising flushing the rack manifold with a volatile fluid; and/or
further comprising tilting or vibrating the rack assembly to drain the coolant
from the rack assembly.

15. The method according to any one of claims 12 to 14, further comprising vacuuming moist air or vapor from volatile fluid from the rack manifold; and/or
further comprising connecting the rack manifold to a coolant distribution unit at
the second location.
